# EUROPEAN PATENT APPLICATION

(11) **EP 4 583 150 A1**
(43) Date of publication of application: **09.07.2025**
(21) Application number: 23900260.3
(22) Date of filing: 01.09.2023
(51) Int. Cl.: H01L 21/3065, G01N 21/27, G01N 21/3504, H04N 25/57, H04N 25/71, H04N 25/76

(54) **SEMICONDUCTOR PROCESS MONITORING DEVICE AND SEMICONDUCTOR PROCESS MONITORING METHOD**

(30) Priority: 06.12.2022 JP 2022194694
(71) Applicant: Hamamatsu Photonics K.K., Hamamatsu-shi, Shizuoka 435-8558 (JP)
(72) Inventor: IGUCHI, Kazuya, Hamamatsu-shi, Shizuoka 435-8558 (JP); MASUOKA, Hideki, Hamamatsu-shi, Shizuoka 435-8558 (JP); OHTSUKA, Kenichi, Hamamatsu-shi, Shizuoka 435-8558 (JP)
(74) Representative: Grünecker Patent- und Rechtsanwälte PartG mbB
(86) International application number: PCT/JP2023/032102
(87) International publication number: WO 2024/122134

(57) **Abstract**

A spectroscopic unit wavelength-resolves measurement light from a chamber in a first direction and forms a spectral image for each wavelength in a second direction intersecting with the first direction, a detection unit includes a first pixel region and a second pixel region divided along the second direction, and a determination unit determines whether or not an abnormality occurs in a semiconductor process based on first spectrum data obtained in a first exposure time in the first pixel region and determines an end point of the semiconductor process based on second spectrum data obtained in a second exposure time, longer than the first exposure time, in the second pixel region.

## Description

### Technical Field

The present disclosure relates to a semiconductor process monitoring device and a semiconductor process monitoring method.

### Background Art

Spectrometry is a technique for detecting a spectral image of measurement light generated in a target and analyzing the object based on spectrum data of the spectral image. In the spectrometry, depending on a type of the object or the like, there is a case where it is required to acquire a spectrum of a high dynamic range (refer to Patent Literature 1). For example, in a process for dry etching the object by a plasma process, light caused by gas to be used for etching is generated, and in addition, light caused by a material to be etched is also generated. In such a semiconductor process, a wavelength band of the light caused by the gas and a wavelength band of the light caused by the material tend to be different from each other. Furthermore, intensity of the light caused by the material tends to be weaker than intensity of the light caused by the gas.

### Citation List

### Patent Literature

Patent Literature 1: Japanese Unexamined Patent Publication No. 2020-118477

### Summary of Invention

### Technical Problem

With recent miniaturization and lamination of semiconductor devices, intensity of measurement light generated in an object in a semiconductor process tends to be weakened. Therefore, in order to monitor the semiconductor process with high accuracy, it is important to measure the intensity of the measurement light with a high dynamic range and high accuracy.

An object of the present disclosure is to provide a semiconductor process monitoring device and a semiconductor process monitoring method that can monitor a semiconductor process with high accuracy, by measuring intensity of measurement light with a high dynamic range and high accuracy.

### Solution to Problem

A semiconductor process monitoring device according to one aspect of the present disclosure includes a spectroscopic unit configured to spectrally disperse measurement light from a chamber, a detection unit configured to detect a spectral image of the measurement light spectrally dispersed by the spectroscopic unit, and a determination unit configured to determine a progress status of a semiconductor process in the chamber, based on data obtained from a detection result of the spectral image of the measurement light, in which the spectroscopic unit wavelength-resolves the measurement light in a first direction and forms a spectral image for each wavelength in a second direction intersecting with the first direction, the detection unit includes a first pixel region and a second pixel region divided along the second direction, and the determination unit determines whether or not an abnormality occurs in the semiconductor process based on first spectrum data obtained in a first exposure time in the first pixel region and determines an end point of the semiconductor process based on second spectrum data obtained in a second exposure time, which is longer than the first exposure time, in the second pixel region.

The semiconductor process monitoring device determines whether or not an abnormality occurs in the semiconductor process based on the first spectrum data obtained in the first exposure time in the first pixel region and determines the end point of the semiconductor process based on the second spectrum data obtained in the second exposure time, which is longer than the first exposure time, in the second pixel region. This semiconductor process monitoring device can measure intensity of the spectral image of the measurement light with a high dynamic range and high accuracy, by combining the detection of the spectral images of the measurement light in the first pixel region and the second pixel region of which the exposure times are different from each other. Therefore, in a case where the measurement light caused by gas with relatively high intensity and the measurement light caused by a material with relatively low intensity are mixed in the semiconductor process, it is possible to highly accurately monitor whether or not an abnormality occurs in the semiconductor process and the end point of the process.

In the first pixel region, the first exposure time may be set to be shorter than a first frame time in the first pixel region, and in the second pixel region, the second exposure time may be set to be the same as a second frame time in the second pixel region. With such a configuration, by combining the detection of the spectral images of the measurement light in the first pixel region and the second pixel region of which the exposure times are different from each other, it is possible to measure the intensity of the spectral image of the measurement light with a high dynamic range and high accuracy. Therefore, in a case where the measurement light caused by the gas with relatively high intensity and the measurement light caused by the material with relatively low intensity are mixed in the semiconductor process, it is possible to highly accurately monitor whether or not an abnormality occurs in the semiconductor process and the end point of the process.

In the first pixel region, the first exposure time may be set so that the measurement light is not saturated at least in a long wavelength region of the measurement light, and in the second pixel region, the second exposure time may be set so that the measurement light is not saturated at least in a short wavelength region of the measurement light. With such a configuration, in the long wavelength region, the first spectrum data can be acquired without saturating the measurement light caused by the gas with relatively high intensity. Furthermore, in the short wavelength region, the second spectrum data regarding the measurement light caused by the material with relatively low intensity can be acquired with an excellent SN ratio. Therefore, accuracy for monitoring whether or not an abnormality occurs in the semiconductor process and the end point of the process can be further enhanced.

A generation unit may combine data in the long wavelength region of the first spectrum data and the data in the short wavelength region of the second spectrum data and output the data to the determination unit. With such a configuration, it is possible to generate spectrum data of the measurement light with a wide dynamic range over an entire wavelength band to be monitored. This makes it possible to easily and accurately determine whether or not an abnormality occurs and the end point of the process.

The determination unit may determine whether or not an abnormality occurs in the semiconductor process, based on whether or not a first peak appears in a predetermined wavelength in the long wavelength region of the first spectrum data and determine the end point of the semiconductor process in a case where a second peak appears in the predetermined wavelength in the short wavelength region of the second spectrum data. By making a determination according to appearance tendency of the peaks of the measurement light caused by the material and the measurement light caused by the gas in the semiconductor process, it is possible to further enhance the accuracy for monitoring whether or not an abnormality occurs in the semiconductor process and the end point of the process.

The detection unit may be a CCD photodetector including a first horizontal shift register to which a charge generated in each column of the first pixel region is transferred, and a second horizontal shift register to which a charge generated in each column of the second pixel region is transferred. With such a configuration, by using the CCD photodetector, it is possible to avoid an increase in read noise when the charges generated in the pixels of each column are read.

The detection unit may be a CCD photodetector including a first accumulation unit in which the charges generated in each column of the first pixel region are accumulated, a second accumulation unit in which the charges generated in each column of the second pixel region are accumulated, a first reading unit configured to output an electrical signal of each column according to an amount of the charges accumulated in the first accumulation unit, and a second reading unit configured to output an electrical signal of each column according to an amount of the charges accumulated in the second accumulation unit. With such a configuration, by using the CCD photodetector, it is possible to avoid the increase in the read noise when the charges generated in the pixels of each column are read.

The detection unit may be a CMOS photodetector including the first reading unit configured to output the electric signal according to the amount of the charges accumulated in each pixel of the first pixel region and the second reading unit configured to output the electric signal according to the amount of the charges accumulated in each pixel of the second pixel region. With such a configuration, for example, power consumption can be suppressed to be lower than that of the CCD photodetector that reads the charges from each column.

The first exposure time of the first pixel region may be controlled by an electronic shutter. With such a configuration, even in a case where the second exposure time is set to be shorter and the first exposure time is set to be sufficiently shorter than the second exposure time, the first exposure time can be accurately adjusted. By setting the first exposure time to be sufficiently shorter than the second exposure time, the dynamic range of the measurement can be further sufficiently increased.

A semiconductor process monitoring method according to one aspect of the present disclosure includes spectrally dispersing measurement light from a chamber, detecting a spectral image of the measurement light spectrally dispersed by the spectrally dispersing measurement light, and determining a progress status of a semiconductor process in the chamber, based on data obtained from a detection result of the spectral image of the measurement light, in which in the spectrally dispersing measurement light, the measurement light is wavelength-resolved in a first direction, and a spectral image is formed for each wavelength in a second direction intersecting with the first direction, in the detecting a spectral image of the measurement light, a photodetector including a first pixel region and a second pixel region divided along the second direction detects the spectral image, and in the determining a progress status of a semiconductor process in the chamber, it is determined whether or not an abnormality occurs in the semiconductor process based on first spectrum data obtained in a first exposure time in the first pixel region, and an end point of the semiconductor process is determined based on second spectrum data obtained in a second exposure time, which is longer than the first exposure time, in the second pixel region.

In this semiconductor process monitoring method, it is determined whether or not an abnormality occurs in the semiconductor process based on the first spectrum data obtained in the first exposure time in the first pixel region, and the end point of the semiconductor process is determined based on the second spectrum data obtained in the second exposure time, which is longer than the first exposure time, in the second pixel region. This semiconductor process monitoring device can measure intensity of the spectral image of the measurement light with a high dynamic range and high accuracy, by combining the detection of the spectral images of the measurement light in the first pixel region and the second pixel region of which the exposure times are different from each other. Therefore, in a case where the measurement light caused by the gas with relatively high intensity and the measurement light caused by the material with relatively low intensity are mixed in the semiconductor process, it is possible to highly accurately monitor whether or not an abnormality occurs in the semiconductor process and the end point of the process.

### Advantageous Effects of Invention

According to the present disclosure, it is possible to provide a semiconductor process monitoring device and a semiconductor process monitoring method that can monitor a semiconductor process with high accuracy, by measuring intensity of measurement light with a high dynamic range and high accuracy.

### Brief Description of Drawings

FIG. 1 is a block diagram illustrating a configuration of a semiconductor process monitoring device according to an embodiment of the present disclosure.
FIG. 2 is a diagram illustrating a configuration of a detection unit illustrated in FIG. 1.
FIG. 3 is a diagram illustrating an example of a CCD photodetector included in the detection unit.
FIG. 4(a) is a timing chart illustrating an operation example of a first pixel region in the detection unit illustrated in FIG. 3. FIG. 4(b) is a timing chart illustrating an operation example of a second pixel region in the detection unit illustrated in FIG. 3.
FIG. 5 is a diagram illustrating another example of the CCD photodetector included in the detection unit.
FIG. 6 is a still another example of the CCD photodetector included in the detection unit.
FIG. 7(a) is a timing chart illustrating an operation example of the first pixel region in the detection unit illustrated in FIGS. 5 and 6. FIG. 7(b) is a timing chart illustrating an operation example of the second pixel region in the detection unit illustrated in FIGS. 5 and 6.
FIG. 8 is a diagram illustrating an example of a CMOS photodetector included in the detection unit.
FIG. 9(a) is a timing chart illustrating an operation example of the first pixel region in the detection unit illustrated in FIG. 8. FIG. 9(b) is a timing chart illustrating an operation example of the second pixel region in the detection unit illustrated in FIG. 8.
FIG. 10 is a flowchart illustrating a semiconductor process monitoring method according to an embodiment of the present disclosure.
FIG. 11 is a detailed flowchart illustrating the semiconductor process monitoring method according to an embodiment of the present disclosure.
FIG. 12 is a diagram illustrating an example of first spectrum data.
FIG. 13 is a diagram illustrating an example of second spectrum data.
FIG. 14 is a diagram for explaining generation of spectrum data of measurement light.
FIG. 15 is a detailed flowchart illustrating the semiconductor process monitoring method according to an embodiment of the present disclosure.
FIG. 16(a) is a diagram illustrating spectrum data in a case where no abnormality occurs. FIG. 16(b) is a diagram illustrating spectrum data in a case where an abnormality occurs.
FIG. 17(a) is a diagram illustrating spectrum data in a case of determining continuation of a semiconductor process. FIG. 17(b) is a diagram illustrating spectrum data in a case of determining an end point of the semiconductor process.

### Description of Embodiments

Hereinafter, a preferred embodiment of a semiconductor process monitoring device and a semiconductor process monitoring method according to an embodiment of the present disclosure will be described in detail with reference to the drawings.

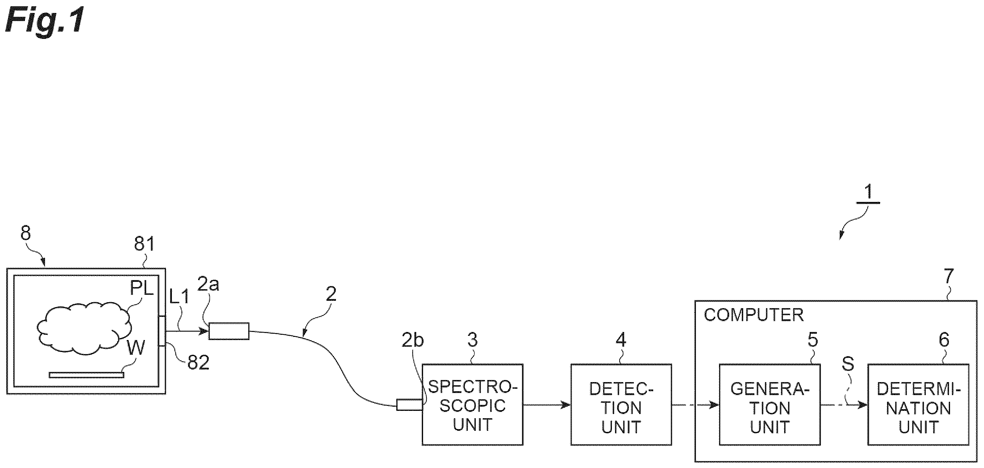

FIG. 1 is a block diagram illustrating a configuration of a semiconductor process monitoring device 1 according to an embodiment of the present disclosure. The semiconductor process monitoring device 1 includes a light guide unit 2, a spectroscopic unit 3, a detection unit 4, a generation unit 5, and a determination unit 6. The generation unit 5 and the determination unit 6 are physically a computer 7 that includes, for example, a processor such as a CPU and a storage medium such as a RAM or a ROM. The computer 7 may be a smartphone integrally including a display unit and an input unit or a smart device such as a tablet terminal. The computer 7 may include a microcomputer or a field-programmable gate array (FPGA). The semiconductor process monitoring device 1 generates spectrum data of measurement light L1 reached from a dry etching device 8 to be measured and performs control based on the spectrum data.

The dry etching device 8 is a device to be used in a dry etching process. The dry etching device 8 includes a chamber 81 and a monitoring window 82. The monitoring window 82 is, for example, colorless and transparent glass and is fitted into a side wall of the chamber 81. An operator of the dry etching device 8 carries a substrate W into the chamber 81, causes etching gas to flow into the chamber 81, and generates plasma PL. The substrate W is etched by the plasma PL. The measurement light L1 from the dry etching device 8 is output to outside through the monitoring window 82. The measurement light L1 includes light caused by gas used for etching and light caused by a material of the substrate W. Although details will be described later, the light caused by the gas tends to appear in a wavelength region of a relatively long wavelength and has relatively high intensity. The light caused by the material tends to appear in a wavelength region of a relatively short wavelength and has relatively low intensity.

The light guide unit 2 guides the measurement light L1 entered from the dry etching device 8 to the spectroscopic unit 3 at a subsequent stage. The light guide unit 2 is, for example, an optical fiber. The light guide unit 2 may be an optical fiber with a single core or may be a bundle fiber in which a plurality of optical fibers is bundled. The light guide unit 2 includes an incidence end 2a and an emission end 2b. The measurement light L1 enters the incidence end 2a and is emitted from the emission end 2b. The incidence end 2a faces the monitoring window 82 of the dry etching device 8 and is disposed at a predetermined interval from the monitoring window 82. The emission end 2b faces the spectroscopic unit 3 and is optically connected to the spectroscopic unit 3, for example, via a connector.

The spectroscopic unit 3 spectrally disperses the measurement light L1 guided by the light guide unit 2 and forms a spectral image on a pixel region of the detection unit 4. The spectroscopic unit 3 spectrally disperses the measurement light L1 into each wavelength component, by a spectroscopic element such as a grating or a prism. As the spectroscopic unit 3, a spectrometer having good imaging properties is used. Examples of the spectrometers that constitute the spectroscopic unit 3 include a Czerny-Turner-type spectrometer capable of performing astigmatism correction, a Dyson-type spectrometer, and an Offner-type spectrometer. The spectroscopic unit 3 wavelength-resolves the measurement light L1 in a first direction parallel to a wavelength axis of the spectral image and forms the spectral image for each wavelength in a second direction intersecting with the first direction in a pixel region 41 of the detection unit 4.

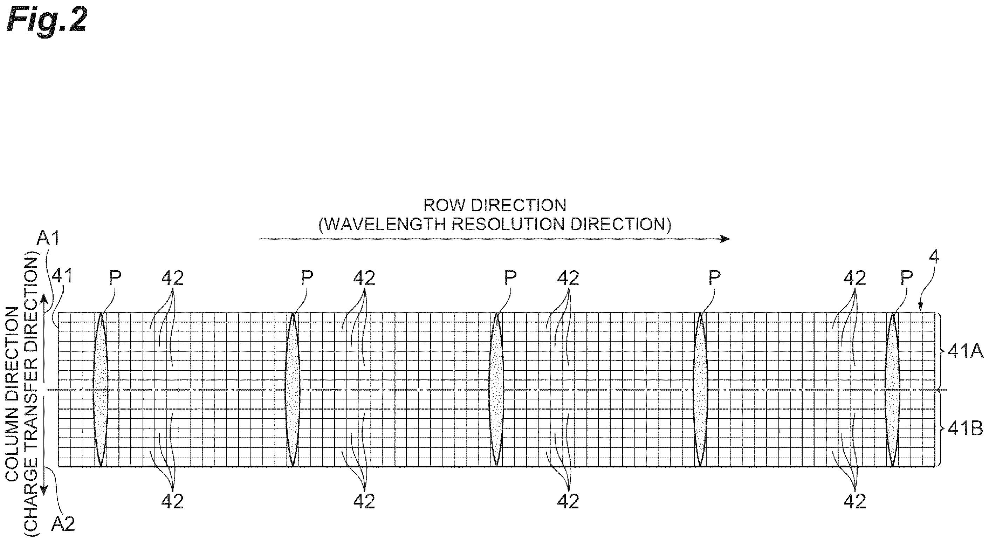

The detection unit 4 detects the measurement light L1 spectrally dispersed by the spectroscopic unit 3. FIG. 2 is a diagram illustrating a configuration of the detection unit 4 illustrated in FIG. 1. As illustrated in FIG. 2, the detection unit 4 includes the pixel region 41 that images a spectral image P. In the pixel region 41, a plurality of pixels 42 are arranged in a row direction and a column direction. In the example of FIG. 2, the row direction corresponding to the first direction is along a wavelength resolution direction of the spectral image P by the spectroscopic unit 3, and the column direction corresponding to the second direction is along a charge transfer direction of each pixel 42. Each pixel 42 receives the wavelength-resolved spectral image P and generates and accumulates charges according to intensity of light. In the example in FIG. 2, the spectral image P is formed as the five spectral images P in a state of being separated from each other along the row direction. Each spectral image P linearly extends in the column direction of the pixel 42.

In the example in FIG. 2, the pixel region 41 has a horizontally long rectangular region in which the number of pixels in the row direction is larger than the number of pixels in the column direction. The pixel region 41 has a first pixel region 41Aand a second pixel region 41B divided along the column direction. Here, the first pixel region 41A and the second pixel region 41B are divided at the center in the column direction. That is, in the pixel region 41, the pixel 42 on one side of the center in the column direction belongs to the first pixel region 41A, and the pixel 42 on another side of the center in the column direction belongs to the second pixel region 41B. Here, a direction from the center of the column direction toward the first pixel region 41A along the column direction is set as a column direction A1, and a direction from the center of the column direction toward the second pixel region 41B along the column direction is set as a column direction A2. The column directions A1 and A2 are directions opposite to each other.

A first exposure time of each pixel 42 in the first pixel region 41A and a second exposure time in each pixel 42 in the second pixel region 41B can be independently set. In the present embodiment, the second exposure time is set to be longer than the first exposure time.

Data obtained from the detection result of the spectral image P of the measurement light L1 is input from the detection unit 4 into the generation unit 5. The generation unit 5 generates spectrum data S of the measurement light L1 based on the detection result of the spectral image P. The generation unit 5 outputs the spectrum data S of the measurement light L1 to the determination unit 6. The determination unit 6 determines a progress status of the semiconductor process in the chamber 81, based on the spectrum data S input from the generation unit 5. The generation unit 5 or the determination unit 6 may control the detection unit 4.

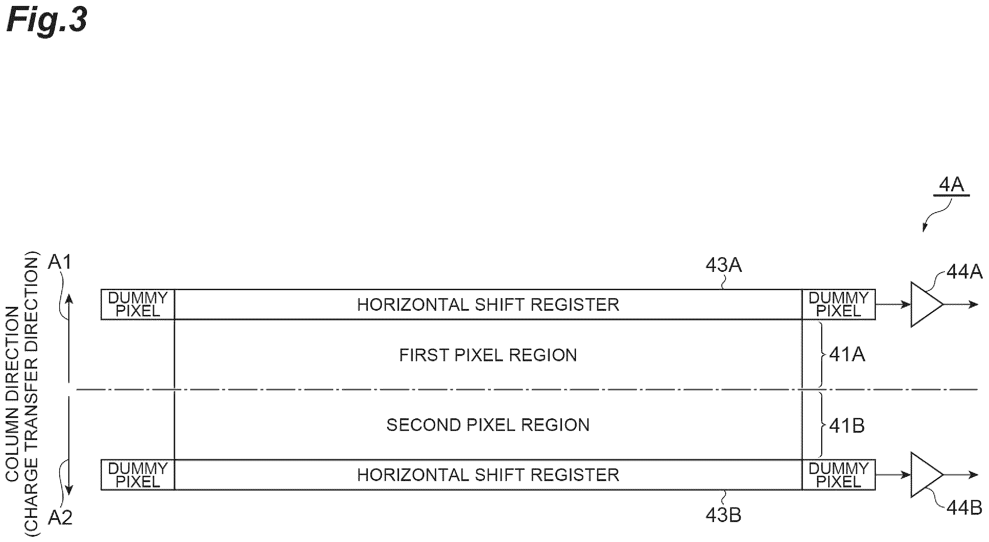

A more detailed specific example of the detection unit 4 will be described with reference to FIGS. 3 to 9. The detection unit 4 includes, for example, a CCD photodetector or a CMOS photodetector. FIG. 3 is a diagram illustrating an example of a CCD photodetector included in a detection unit 4A. The detection unit 4A includes the pixel region 41 including the first pixel region 41A and the second pixel region 41B, a first horizontal shift register 43A corresponding to the first pixel region 41A, a second horizontal shift register 43B corresponding to the second pixel region 41B, and a dummy pixel.

In the first pixel region 41A, the charge generated and accumulated in each pixel 42 is transferred to the first horizontal shift register 43A along the column direction A1, and the charges in the pixel 42 in each column are added for each column in the first horizontal shift register 43A (hereinafter, this operation is referred to as "vertical transfer"). Thereafter, the charges added for each column in the first horizontal shift register 43A are sequentially read from the first horizontal shift register 43A (hereinafter, this operation is referred to as "horizontal transfer"). Then, an electric signal (for example, signal indicating voltage value) according to an amount of the charges read from the first horizontal shift register 43Ais output from a first amplifier 44A, and the electric signal is AD-converted into a digital value by an AD converter. The digital value is output to the generation unit 5.

In the second pixel region 41B, the charge generated and accumulated in each pixel 42 is transferred to the second horizontal shift register 43B along the column direction A2, and the charges in the pixel 42 in each column are added for each column in the second horizontal shift register 43B (vertical transfer). Thereafter, the charges added for each column in the second horizontal shift register 43B are sequentially read from the second horizontal shift register 43B (horizontal transfer). Then, an electric signal (for example, signal indicating voltage value) according to an amount of the charges read from the second horizontal shift register 43B is output from a second amplifier 44B, and the electric signal is AD-converted into a digital value by the AD converter. The digital value is output to the generation unit 5.

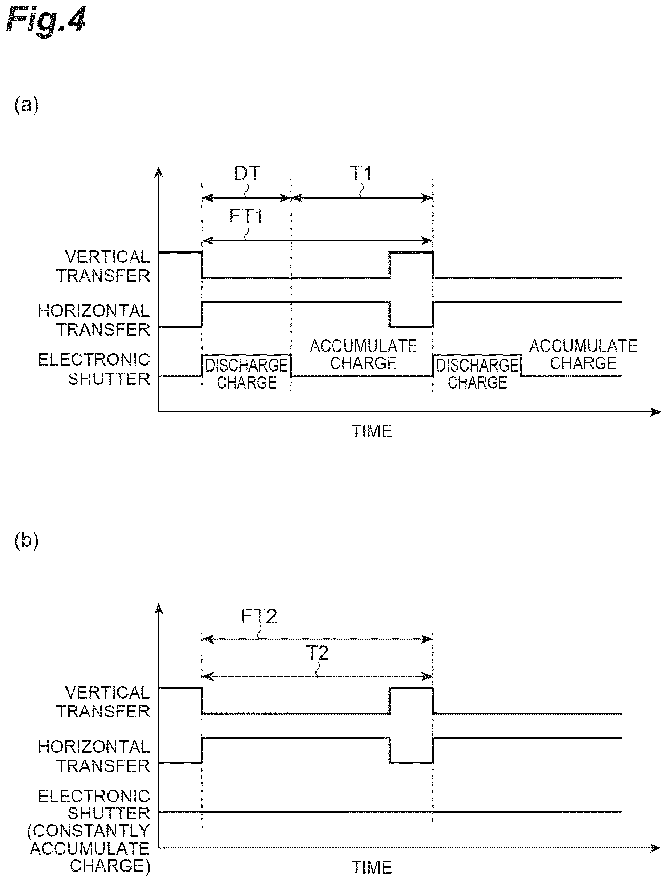

FIG. 4 is a timing chart illustrating an operation example of the detection unit 4A illustrated in FIG. 3. This figure is a timing chart in a case where a full-frame transfer-type CCD image sensor is used. In this case, a half of the charges accumulated in a vertical transfer period is transferred to a horizontal shift register by the vertical transfer, and another half is transferred to the horizontal shift register by next vertical transfer. FIG. 4(a) is a timing chart illustrating an operation example of the first pixel region 41A. A first exposure time T1 can be set by an electronic shutter. The electronic shutter can be realized, for example, by using an anti-blooming gate (ABG).

The electronic shutter switches accumulation of the charges generated in the first pixel region 41A and discharge of the accumulated charges. In the example in FIG. 4(a), a period from start of the horizontal transfer by the first horizontal shift register 43A to end of the next vertical transfer is referred to as a first frame time FT1. The first frame time FT1 corresponds to a reciprocal of a frame rate of the first pixel region 41A. In that case, the detection unit 4A discharges the charges in a predetermined time period DT from start of the first frame time FT1, by switching the electronic shutter during the horizontal transfer. As a result, the detection unit 4A sets a time period obtained by removing the predetermined time period DT from the first frame time FT1, as the first exposure time T1. Therefore, in the example in FIG. 4(a), the first exposure time T1 is shorter than the first frame time FT1.

FIG. 4(b) is a timing chart illustrating an operation example of the second pixel region 41B. In the operation example of the second pixel region 41B, the electronic shutter is constantly turned off, and the charges are constantly accumulated. In the example in FIG. 4(b), a time period from start of the horizontal transfer by the second horizontal shift register 43B to end of the next vertical transfer is referred to as a second frame time FT2. The second frame time FT2 corresponds to a reciprocal of a frame rate of the second pixel region 41B. A second exposure time T2 coincides with the second frame time FT2. Furthermore, in the example in FIG. 4, although the first frame time FT1 and the second frame time FT2 are the same, the first frame time FT1 and the second frame time FT2 may be different from each other.

The second exposure time T2 can be set to be longer than the first exposure time T1, without using the electronic shutter. For example, the detection unit 4A sets a cycle of outputting digital data from the second pixel region 41B to the generation unit 5 to five times a cycle of outputting digital data from the first pixel region 41A to the generation unit 5. In this case, the second exposure time T2 is about five times the first exposure time T1. Furthermore, the second frame time FT2 may be set to be five times the first frame time FT1, or a second frame rate may be set to be 1/5 times a first frame rate. In these cases, the second exposure time T2 is about five times the first exposure time T1.

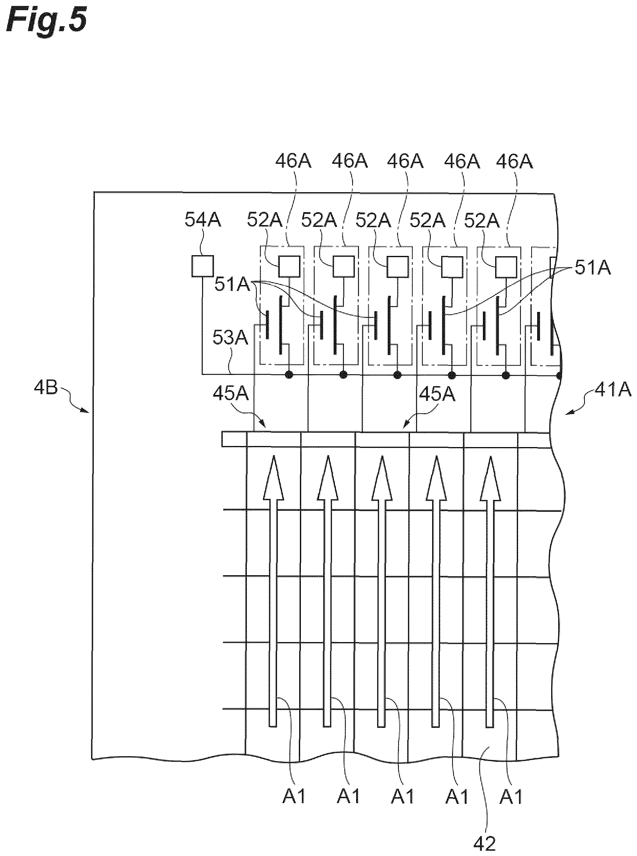

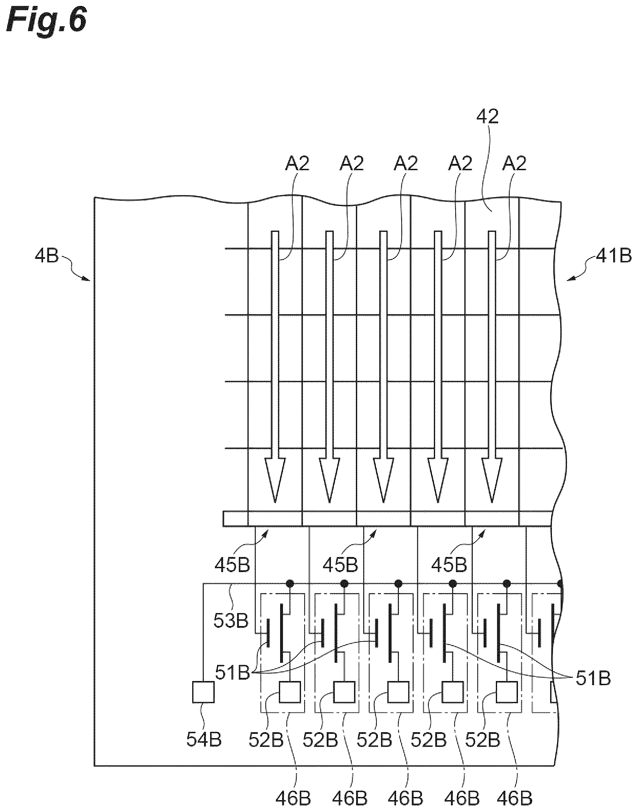

FIGS. 5 and 6 are diagrams illustrating another example of a CCD photodetector included in a detection unit 4B. The detection unit 4B includes a first accumulation unit 45A in which the charges generated in each column of the first pixel region 41A are accumulated, a second accumulation unit 45B in which the charges generated in each column of the second pixel region 41B are accumulated, a first reading unit 46A that outputs the electric signal of each column according to an amount of the charges accumulated in the first accumulation unit 45A, and a second reading unit 46B that outputs the electric signal of each column according to an amount of the charges accumulated in the second accumulation unit 45B.

The first accumulation unit 45A is arranged for each column at an end of the first pixel region 41A in the column direction A1. The charge generated in the pixel 42 in each column belonging to the first pixel region 41A is vertically transferred along the column direction A1 and accumulated in the first accumulation unit 45A. The second accumulation unit 45B is arranged for each column at an end of the second pixel region 41B in the column direction A2. The charge generated in the pixel 42 in each column belonging to the second pixel region 41B is vertically transferred along the column direction A2 and accumulated in the second accumulation unit 45B.

The first reading unit 46A is arranged at a subsequent stage of the first accumulation unit 45A at an end on the side of the first pixel region 41A, and the second reading unit 46B is arranged at a subsequent stage of the second accumulation unit 45B at an end on the side of the second pixel region 41B. The first reading unit 46A outputs a first electric signal of each column according to the amount of the charges accumulated by the first accumulation unit 45A. The second reading unit 46B outputs a second electric signal of each column according to the amount of the charges accumulated by the second accumulation unit 45B. The first electric signal and the second electric signal are, for example, signals indicating a voltage value.

As illustrated in FIG. 5, the first reading unit 46A includes a transistor 51A and a bonding pad for signal output 52A. A control terminal (gate) of the transistor 51A is electrically connected to the first accumulation unit 45A. One current terminal (drain) of the transistor 51A is electrically connected to a bonding pad 54A via a wiring line 53A provided in common throughout the columns of the first pixel region 41A. A voltage of a predetermined magnitude is always applied to the bonding pad 54A.

Another current terminal (source) of the transistor 51A is electrically connected to the bonding pad for signal output 52A. A voltage according to the first electric signal output from the first accumulation unit 45A is applied to the control terminal of the transistor 51A. From the other current terminal of the transistor 51A, electric current according to the applied voltage is output and is taken out via the bonding pad for signal output 52A. After being amplified by the first amplifier, the first electric signal output from the bonding pad for signal output 52A is output to the AD converter. The first electric signal is AD-converted into a digital value by the AD converter. The digital value is output to the generation unit 5.

As illustrated in FIG. 6, the second reading unit 46B includes a transistor 51B and a bonding pad for signal output 52B. A control terminal (gate) of the transistor 51B is electrically connected to the second accumulation unit 45B. One current terminal (drain) of the transistor 51B is electrically connected to a bonding pad 54B via a wiring line 53B provided in common throughout the columns of the second pixel region 41B. A voltage of a predetermined magnitude is always applied to the bonding pad 54B.

Another current terminal (source) of the transistor 51B is electrically connected to the bonding pad for signal output 52B. A voltage according to the second electrical signal output from the second accumulation unit 45B is applied to the control terminal of the transistor 51B. From the other current terminal of the transistor 51B, electric current according to the applied voltage is output and taken out via the bonding pad for signal output 52B. After being amplified by the second amplifier, the second electric signal output from the bonding pad for signal output 52B is output to the AD converter. The second electric signal is AD-converted into a digital value by the AD converter. The digital value is output to the generation unit 5.

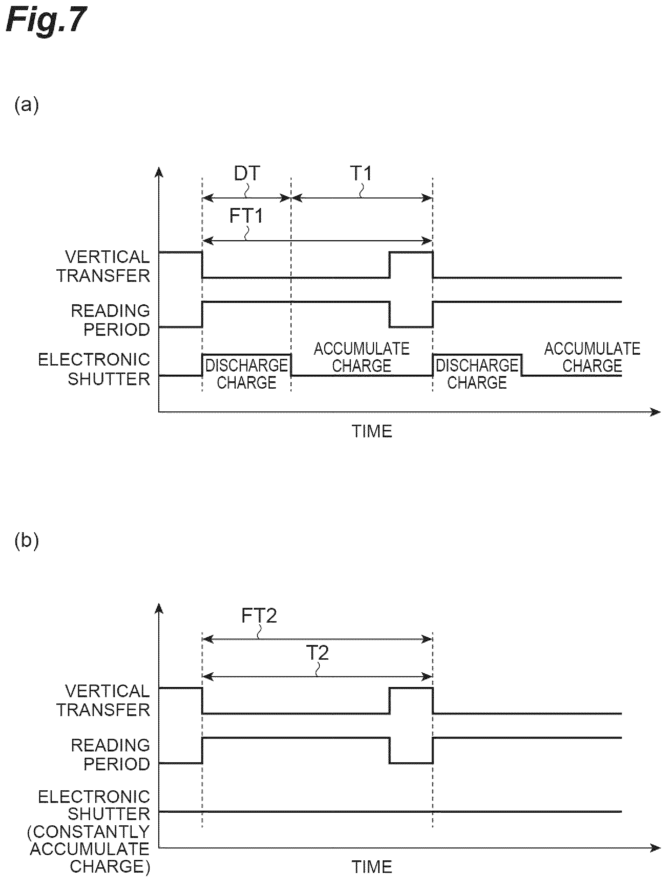

FIG. 7 is a timing chart illustrating an operation example of the detection unit 4B illustrated in FIGS. 5 and 6. FIG. 7(a) is a timing chart illustrating an operation example of the first pixel region 41A. FIG. 7(b) is a timing chart illustrating an operation example of the second pixel region 41B. Only points different from those of the operation example of the detection unit 4A described with reference to FIG. 4 will be described. In the example in FIG. 7(a), a time period from start of reading the charges accumulated in the first accumulation unit 45A, by the first reading unit 46A to output of the first electric signal in each column according to the amount of the charges is set as a reading period. In the example in FIG. 7(a), a time period from start of the reading period to end of next vertical transfer is referred to as the first frame time FT1. The detection unit 4B discharges the charges over the predetermined time period DT, from the start of the first frame time FT1, by switching the electronic shutter during the reading period. As a result, the detection unit 4B sets a time period obtained by removing the predetermined time period DT from the first frame time FT1, as the first exposure time T1. Therefore, in the example in FIG. 7(a), the first exposure time T1 is shorter than the first frame time FT1. In the example in FIG. 7(b), a time period from the start of the reading period to end of the next vertical transfer is referred to as the second frame time FT2. A second exposure time T2 coincides with the second frame time FT2.

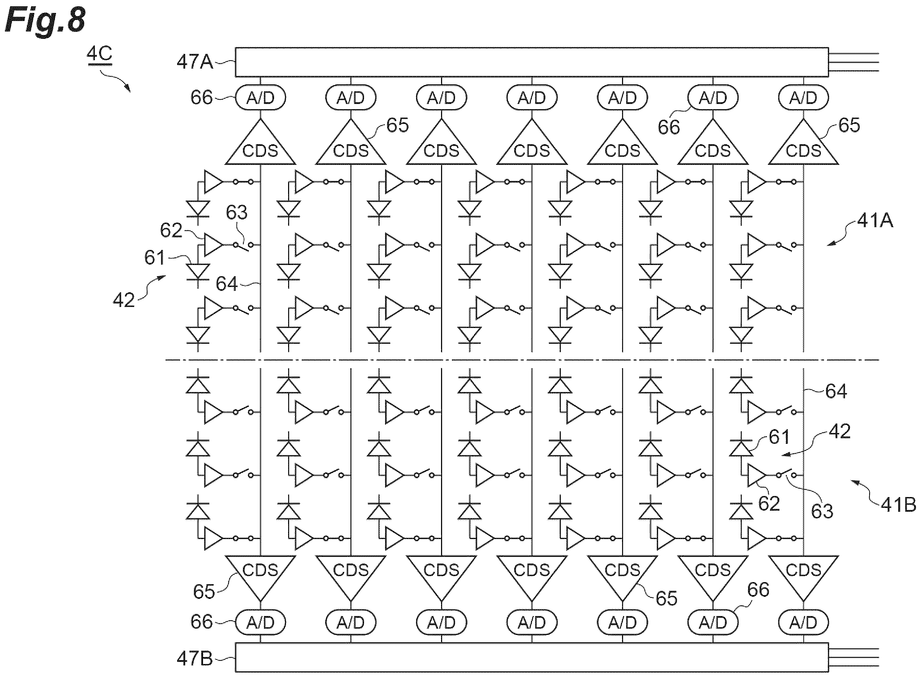

FIG. 8 is a diagram illustrating an example of a CMOS photodetector included in a detection unit 4C. The detection unit 4C includes the first pixel region 41A, the second pixel region 41B, a first reading unit 47A, and a second reading unit 47B. Each pixel 42 in the first pixel region 41A and the second pixel region 41B includes a photodiode 61 and an amplifier 62. The photodiode 61 accumulates electrons (photoelectrons) generated by inputting the measurement light L1 as charges. The amplifier 62 converts the charge accumulated in the photodiode 61 into an electric signal (for example, signal indicating voltage value) and amplifies the electric signal. Furthermore, the amplifier 62 may include a capacitance unit (not illustrated) connected between an input terminal and an output terminal and a reset switch (not illustrated) connected to the capacitance unit in parallel. In this case, when receiving a reset signal from an external control circuit (for example, generation unit 5), the detection unit 4C resets (discharge) charges accumulated in the capacitance unit by turning on the reset switch.

The electric signal amplified by the amplifier 62 is transferred to a vertical signal line 64 that connects between the pixels 42 in the row direction, by switching a selection switch 63 of each pixel 42. A correlated double sampling (CDS) circuit 65 is arranged in each vertical signal line 64. The CDS circuit 65 reduces read noise between the pixels 42 and temporarily stores the electric signal transferred to the vertical signal line 64.

An AD converter 66 converts a voltage value stored in the CDS circuit 65 into a digital value. A digital value corresponding to the first pixel region 41A is output to the generation unit 5 via the first reading unit 47A. That is, the electric signal according to the amount of the charges accumulated in each pixel 42 of the first pixel region 41A is output from the first reading unit 47A. A digital value corresponding to the second pixel region 41B is output to the generation unit 5 via the second reading unit 47B. That is, the electric signal according to the amount of the charges accumulated in each pixel 42 of the second pixel region 41B is output from the second reading unit 47B.

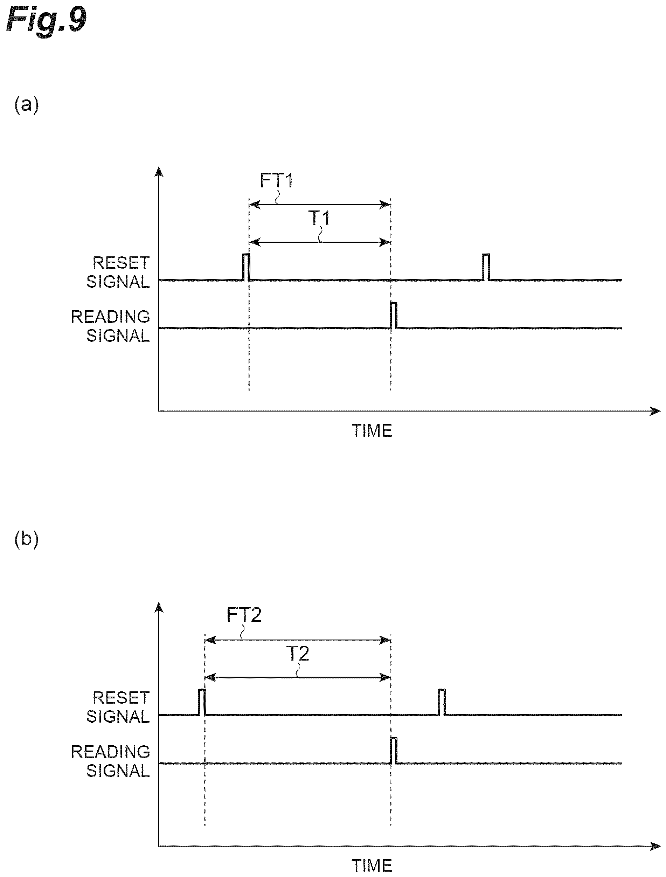

FIG. 9 is a timing chart illustrating an operation example of the detection unit 4C illustrated in FIG. 8. FIG. 9(a) is a timing chart illustrating an operation example of the first pixel region 41A. FIG. 9(b) is a timing chart illustrating an operation example of the second pixel region 41B. The detection unit 4C discharges the accumulated charges while receiving a reset signal from an external control circuit (for example, generation unit 5). The reset signal is, for example, a pulse. The detection unit 4C discharges the accumulated charges, while the pulse is at a Hi level. When receiving a reading signal from the external control circuit (for example, generation unit 5), the detection unit 4C outputs a digital value to the generation unit 5 via the first reading unit 47A and outputs a digital value to the generation unit 5 via the second reading unit 47B. The reading signal is, for example, a pulse. In the example in FIG. 9, a time period from fall of the reset signal to rise of the reading signal is set as an exposure time. In the example in FIG. 9, the time period from the fall of the reset signal to the rise of the reading signal may be adjusted by the electronic shutter. In this case, the first exposure time T1 and the second exposure time T2 can be individually set by the electronic shutter. In the example in FIG. 9(a), the first exposure time T1 corresponds to the first frame time FT1. In the example in FIG. 9(b), the second exposure time T2 corresponds to the second frame time FT2. Alternatively, the time period from the fall of the reset signal to fall of the next reset signal may be set as the first frame time FT1 and the second frame time FT2. In that case, the first exposure time T1 may be shorter than the first frame time FT1, and the second exposure time T2 may be shorter than the second frame time FT2.

Here, a relationship between the first exposure time T1 and a dynamic range will be described. Similarly, a relationship between the second exposure time T2 and the dynamic range will be described. The dynamic range is calculated by multiplying a ratio between a maximum level and a minimum level that are detectable by a ratio between the second exposure time T2 and the first exposure time T1. The detectable maximum level is, for example, the maximum number of output bits of the AD converter. Specifically, in a case of 16 bits, the number is 65535 in 10 decimal notation. The detectable minimum level is a noise level that can be detected by the detection unit 4. Since the ratio between the maximum level and the minimum level that are detectable is a value determined according to a specification of the detection unit 4, the dynamic range depends on the ratio between the second exposure time T2 and the first exposure time T1.

The detection units 4A, 4B, and 4C can set the dynamic range in a wide range, by controlling the first exposure time T1 using the electronic shutter. In the detection units 4A and 4B, a frame time of an image sensor is about 10 ms at the shortest. In a case where the electronic shutter is not used, when the dynamic range (ratio between second exposure time T2 and first exposure time T1) is set to 100, the second exposure time T2 is 1000 ms. In this case, a sampling interval is too large in monitoring the semiconductor process. Therefore, in a case where the first exposure time T1 is set to 1 ms, which is a time shorter than the first frame time FT1, using the electronic shutter, the second exposure time T2 is 100 ms. As compared with a case where the electronic shutter is not used, the sampling interval can be shortened to 1/10. Also in the detection unit 4C, the dynamic range can be increased, by individually setting the first exposure time T1 and the second exposure time T2 using the electronic shutter.

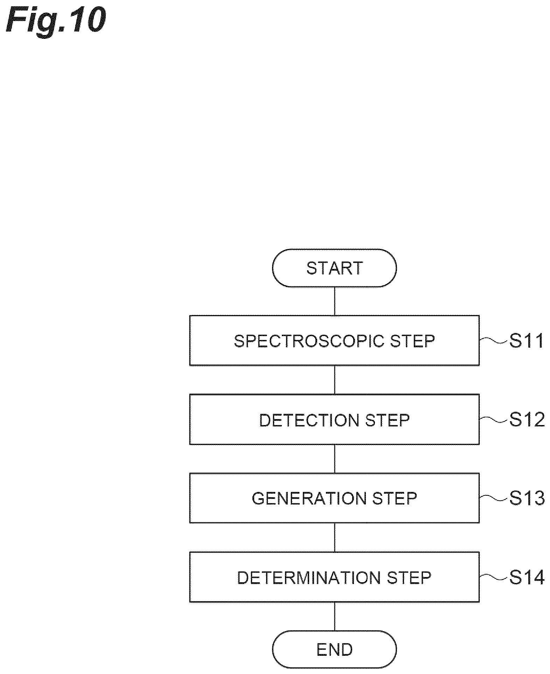

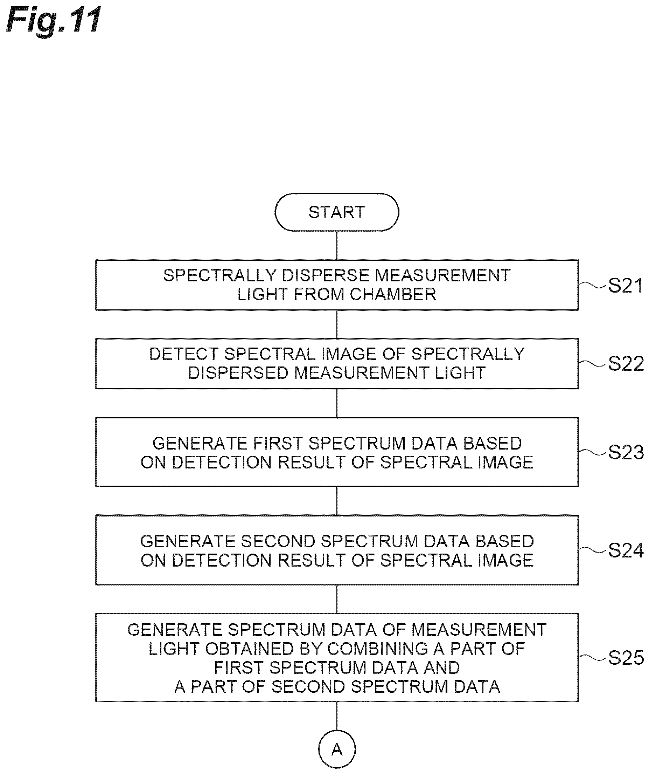

FIG. 10 is a flowchart illustrating the semiconductor process monitoring method according to an embodiment of the present disclosure. The monitoring method includes a spectroscopic step S11, a detection step S12, a generation step S13, and a determination step S14. FIG. 11 is a detailed flowchart illustrating the semiconductor process monitoring method according to an embodiment of the present disclosure. FIG. 11 corresponds to the spectroscopic step S11, the detection step S12, and the generation step S13 in FIG. 10. The spectroscopic unit 3 spectrally disperses the measurement light L1 from the chamber 81 (step S21). The detection unit 4 detects the spectrally dispersed measurement light L1 (step S22). The detection unit 4 outputs data obtained from a result of detecting the measurement light L1, to the generation unit 5. The generation unit 5 generates first spectrum data based on a detection result of the spectral image P in the first pixel region 41A (step S23). The generation unit 5 generates second spectrum data based on a detection result of the spectral image P in the second pixel region 41B (step S24). Steps S23 and S24 may be simultaneously performed or one of steps S23 and S24 may be performed first.

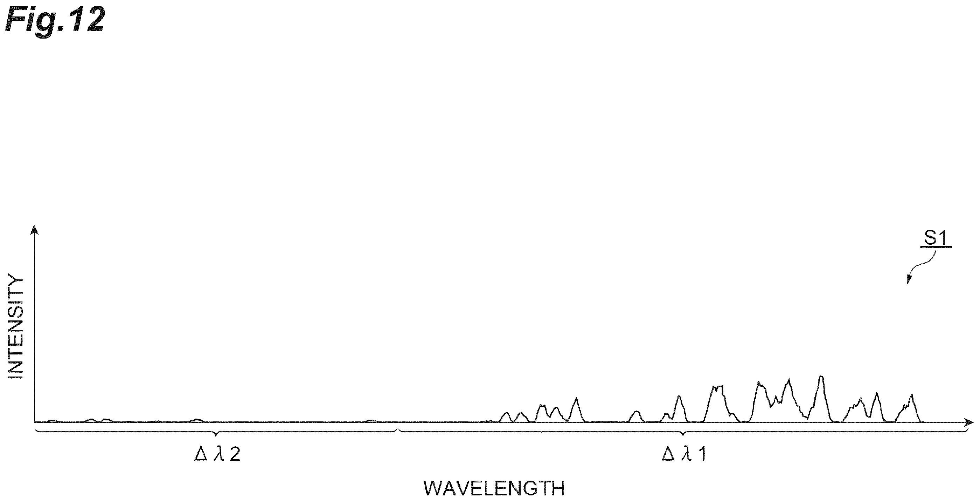

FIG. 12 is a diagram illustrating an example of first spectrum data S1. As illustrated in FIG. 12, in the first spectrum data S1, the measurement light L1 is not saturated in all wavelength bands, and the generation unit 5 acquires intensity without saturation in all the wavelength bands. Here, a wavelength band in which the measurement light L1 has high intensity tends to be a longer wavelength than a wavelength band in which the measurement light L1 has low intensity. The measurement light L1 with a long wavelength and high intensity tends to be caused by the etching gas, and the measurement light L1 with a short wavelength and low intensity tends to be caused by the material to be etched. Therefore, a wavelength region including the wavelength band in which the measurement light L1 has high intensity is set to a long wavelength region Δλ1, and a wavelength region including the wavelength band in which the measurement light L1 has low intensity is set to a short wavelength region Δλ2. A wavelength at a boundary between the long wavelength region Δλ1 and the short wavelength region Δλ2 is, for example, 400 nm that is a boundary between a wavelength of ultraviolet light and a wavelength of visible light.

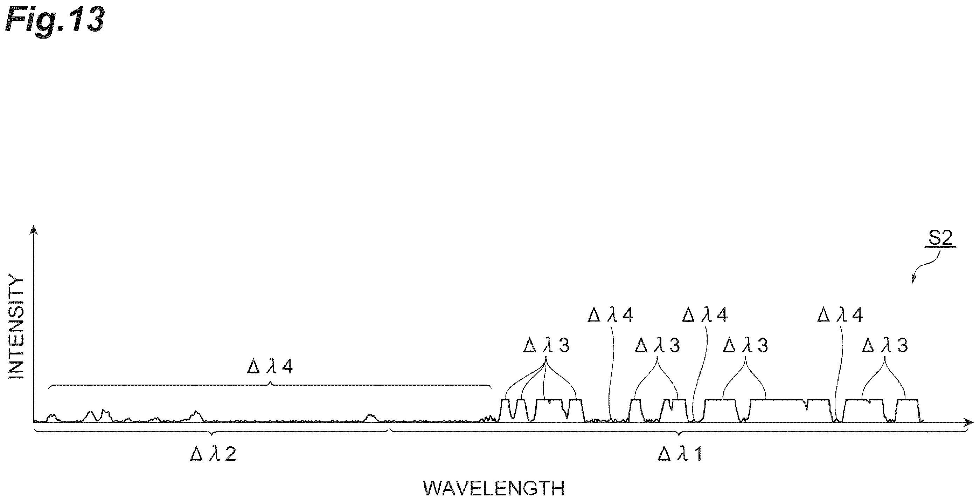

FIG. 13 is a diagram illustrating an example of second spectrum data S2. In the second spectrum data S2, the long wavelength region Δλ1 includes a wavelength band in which the measurement light L1 is saturated (saturated wavelength band Δλ3). On the other hand, in the second spectrum data S2, the short wavelength region Δλ2 includes a wavelength band in which the measurement light L1 is not saturated (non-saturated wavelength band Δλ4). On the other hand, in the first spectrum data S1, in a wavelength band corresponding to the saturated wavelength band Δλ3 of the second spectrum data S2 in the long wavelength region Δλ1, intensity can be accurately acquired. That is, in the first pixel region 41A, the first exposure time T1 is set so that the measurement light L1 is not saturated at least in the long wavelength region Δλ1 of the measurement light L1.

In the first spectrum data S1, in the wavelength band corresponding to the non-saturated wavelength band Δλ4 of the second spectrum data in the short wavelength region Δλ2, noise is superimposed, and an SN ratio is poor. On the other hand, in the second spectrum data S2, in the short wavelength region Δλ2 (non-saturated wavelength band Δλ4), the noise is not superimposed, and the generation unit 5 can acquire data with high accuracy. That is, in the second pixel region 41B, the second exposure time T2 is set so that the measurement light L1 is not saturated at least in the short wavelength region Δλ2 (non-saturated wavelength band Δλ4) of the measurement light L1.

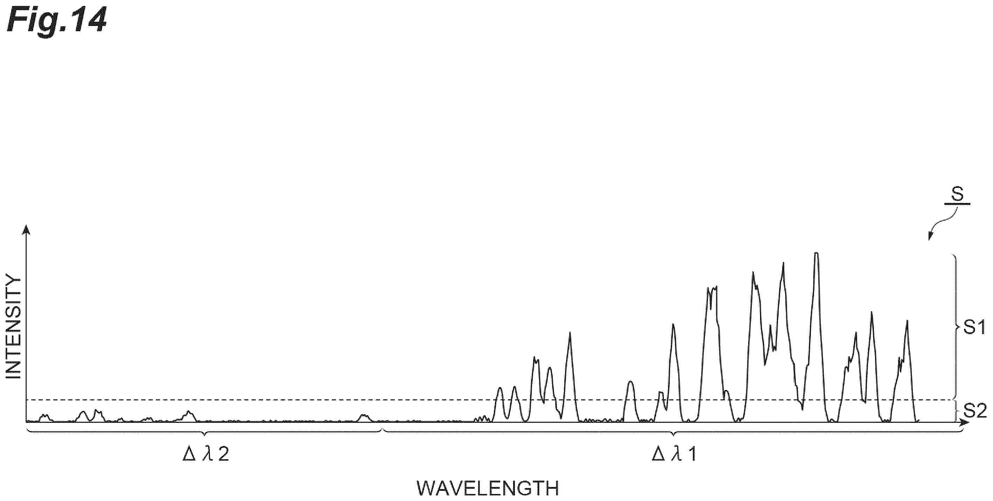

Subsequently, the generation unit 5 combines (couple) a part of data of the first spectrum data S1 and a part of data of the second spectrum data S2 and the generation unit 5 generates the spectrum data S of the measurement light L1 (step S25). For example, the generation unit 5 may combine (couple) data regarding the wavelength band corresponding to the saturated wavelength band Δλ3 of the second spectrum data S2 in the first spectrum data S1 and data in the non-saturated wavelength band Δλ4 of the second spectrum data S2 and generate the spectrum data S of the measurement light L1. Furthermore, the generation unit 5 may combine (couple) data in the long wavelength region Δλ1 of the first spectrum data S1 and data in the short wavelength region Δλ2 of the second spectrum data S2 and generate the spectrum data S of the measurement light L1. FIG. 14 is a diagram for explaining the generation of the spectrum data S of the measurement light L1. For example, the generation unit 5 generates the spectrum data S of the measurement light L1 as follows. For the first spectrum data S1, the first spectrum data S1 is divided by the first exposure time T1, and a divided result is multiplied by a reference exposure time. On the other hand, for the second spectrum data S2, the generation unit 5 divides the second spectrum data S2 by the second exposure time T2 and multiplies a divided result by the reference exposure time. As a result, the generation unit 5 generates the spectrum data S of the measurement light L1, after matching a scale of the first spectrum data S1 and a scale of the second spectrum data S2. In the spectrum data S, intensity with no saturation is acquired in all the wavelength bands, without the saturation of the measurement light L1 in all the wavelength bands and the superimposition of the noise.

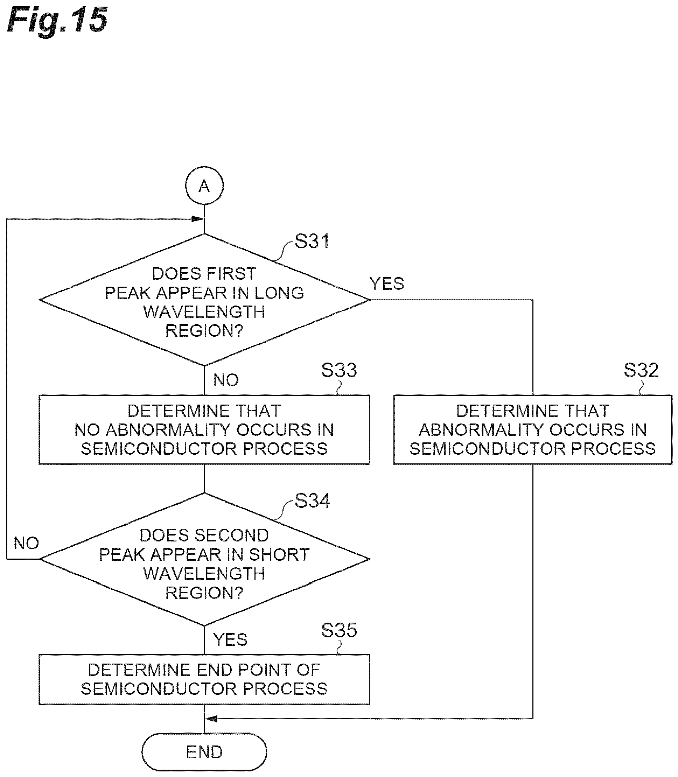

FIG. 15 is a detailed flowchart illustrating the semiconductor process monitoring method according to an embodiment of the present disclosure. FIG. 15 corresponds to the determination step S14 in FIG. 10. The determination unit 6 determines whether or not an abnormality occurs in the semiconductor process, based on the spectrum data S of the measurement light L1. First, the determination unit 6 determines whether or not a first peak appears in a predetermined wavelength (for example, wavelength of 600 nm to 800 nm) in the long wavelength region Δλ1 of the spectrum data S (step S31). In a case where the first peak appears (step S31: YES), the determination unit 6 determines that an abnormality occurs in the semiconductor process (step S32). In that case, the determination unit 6 may issue an alarm to an operator of the device or may end an etching process. Then, a series of determination flows ends. Note that step S34 includes that the determination unit 6 determines that the abnormality occurs in the semiconductor process, based on the spectrum data in both in the long wavelength region Δλ1 and the short wavelength region Δλ2 of the spectrum data S.

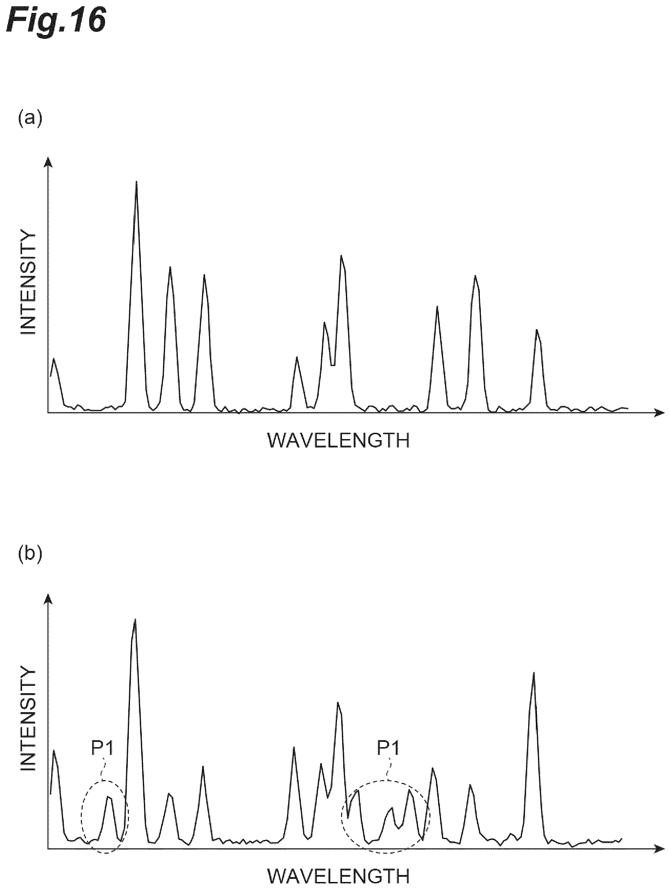

FIG. 16 is a diagram for explaining processing for determining whether or not an abnormality occurs in the semiconductor process. FIG. 16 is an enlarged view of the data in the long wavelength region Δλ1 of the spectrum data S. FIG. 16(a) illustrates spectrum data S in a case where no abnormality occurs. FIG. 16(b) illustrates spectrum data S in a case where an abnormality occurs. In FIG. 16(b), in a wavelength band where no peak is generated in FIG. 16(a), a first peak P1 is generated. The first peak P1 is generated, for example, due to nitrogen gas mixed from outside. For example, while a door of the chamber 81 is repeatedly opened/closed, a seal member between the door and a main body of the chamber 81 is worn, and when inside of the chamber is evacuated, there may be a case where nitrogen gas is mixed from outside. At that time, by detecting the first peak P1 generated in a case where the nitrogen gas mixed from outside is equal to or more than a predetermined value, a state where gas is excessively mixed from outside into an etching chamber can be detected with high accuracy as an abnormal state.

In a case where the first peak P1 is not detected (step S31: NO), the determination unit 6 determines that no abnormality occurs in the semiconductor process (step S33). Subsequently, the determination unit 6 determines the end point of the semiconductor process. First, the determination unit 6 determines whether or not a second peak is detected in a predetermined wavelength (for example, wavelength of 300 nm to 400 nm) in the short wavelength region Δλ2 of the spectrum data S (step S34). In a case where the second peak is not detected (step S34: NO), the determination unit 6 determines to continue the semiconductor process, and a determination flow returns to step 31. On the other hand, in a case where the second peak is detected (step S34: YES), the determination unit 6 determines the end point of the semiconductor process (step S35) and ends the determination flow. Note that step S34 includes that the determination unit 6 determines that no abnormality occurs in the semiconductor process, based on the spectrum data in both of the long wavelength region Δλ1 and the short wavelength region Δλ2 of the spectrum data S.

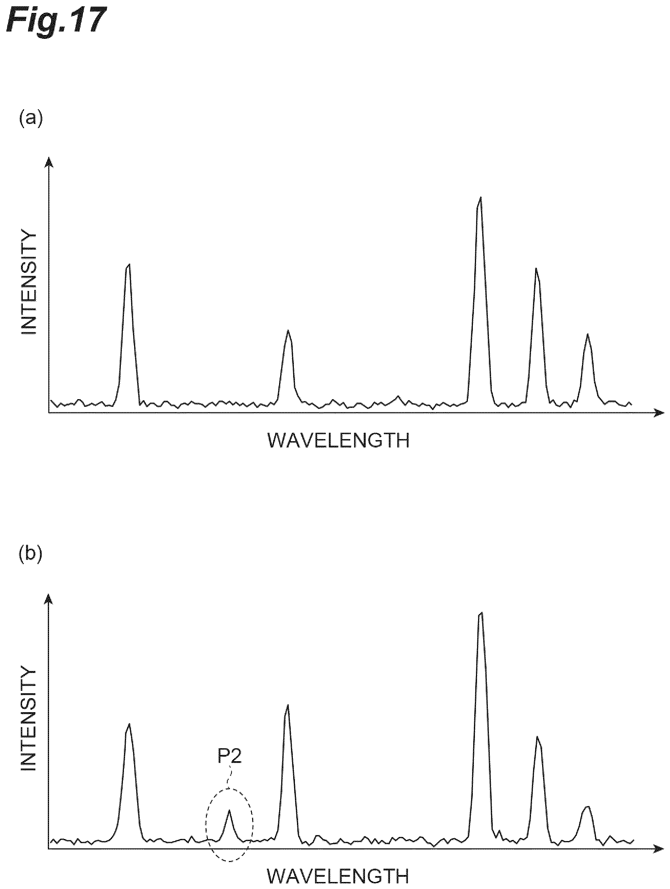

FIG. 17 is a diagram for explaining processing for determining the end point of the semiconductor process. FIG. 17 enlarges and illustrates data in the short wavelength region Δλ2 of the spectrum data S. FIG. 17(a) illustrates the spectrum data S in a case where continuation of the semiconductor process is determined. FIG. 17(b) illustrates the spectrum data S in a case where the end point of the semiconductor process is determined. In FIG. 17(b), in a wavelength band where no peak is generated in FIG. 17(a), a second peak P2 is generated. The second peak P2 is generated due to the material to be etched. For example, it is assumed that a base layer is formed on the substrate W and an etching target layer is formed on the base layer. In this case, the second peak P2 is generated due to the base layer. When the etching process proceeds and etching of the etching target layer is completed, the base layer may be exposed on an etching pattern bottom surface. At that time, by detecting the second peak P2, it can be detected with high accuracy that the etching process ends and the base layer is exposed.

As described above, the semiconductor process monitoring device 1 according to one aspect of the present disclosure determines whether or not an abnormality occurs in the semiconductor process based on the first spectrum data S1 obtained in the first exposure time T1 in the first pixel region 41A and determines the end point of the semiconductor process based on the second spectrum data S2 obtained in the second exposure time T2, longer than the first exposure time T1, in the second pixel region 41B. Note that whether or not an abnormality occurs in the semiconductor process can be determined based on the spectrum data S of both of the first spectrum data S1 and the second spectrum data S2. This semiconductor process monitoring device can measure the intensity of the spectral image P of the measurement light L1 with a high dynamic range and high accuracy, by combining the detection of the spectral images P of the measurement light L1 in the first pixel region 41Aand the second pixel region 41B of which the exposure times are different from each other. Therefore, even in a case where the measurement light L1 caused by the gas with relatively high intensity and the measurement light L1 caused by the material with relatively low intensity are mixed in the semiconductor process, it is possible to highly accurately monitor whether or not an abnormality occurs in the semiconductor process and the end point of the process.

In the first pixel region 41A, the first exposure time T1 is set to be shorter than the first frame time FT1 in the first pixel region 41A, and in the second pixel region 41B, the second exposure time T2 is set to be the same as the second frame time FT2 in the second pixel region 41B. With such a configuration, by combining the detection of the spectral images P of the measurement light L1 in the first pixel region 41Aand the second pixel region 41B of which the exposure times are different from each other, it is possible to measure the intensity of the spectral image P of the measurement light L1 with a high dynamic range and high accuracy. Therefore, even in a case where the measurement light L1 caused by the gas with relatively high intensity and the measurement light L1 caused by the material with relatively low intensity are mixed in the semiconductor process, it is possible to highly accurately monitor whether or not an abnormality occurs in the semiconductor process and the end point of the process.

In the first pixel region 41A, the first exposure time T1 is set so that the measurement light L1 is not saturated at least in the long wavelength region Δλ1 (wavelength band corresponding to saturated wavelength band Δλ3 of second spectrum data S2 in long wavelength region Δλ1) of the measurement light L1, and in the second pixel region 41B, the second exposure time T2 is set so that the measurement light L1 is not saturated at least in the short wavelength region Δλ2 of the measurement light L1. With such a configuration, in the long wavelength region Δλ1, the first spectrum data S1 can be acquired without saturating the measurement light L1 caused by the gas with relatively high intensity. Furthermore, in the short wavelength region Δλ2, the second spectrum data S2 regarding the measurement light L1 caused by the material with relatively low intensity can be acquired with an excellent SN ratio. Therefore, accuracy for monitoring whether or not an abnormality occurs in the semiconductor process and the end point of the process can be further enhanced.

The generation unit 5 combines (couple) the data in the long wavelength region Δλ1 of the first spectrum data S1 and the data in the short wavelength region Δλ2 of the second spectrum data S2 and the generation unit 5 outputs the data to the determination unit 6. With such a configuration, it is possible to generate the spectrum data S of the measurement light L1 with a wide dynamic range over an entire wavelength band to be monitored. This makes it possible to easily and accurately determine whether or not an abnormality occurs and the end point of the process.

The determination unit 6 determines whether or not an abnormality occurs in the semiconductor process, based on whether or not the first peak P1 appears in the predetermined wavelength in the long wavelength region Δλ1 of the first spectrum data S1 and determines the end point of the semiconductor process in a case where the second peak P2 appears in the predetermined wavelength in the short wavelength region Δλ2 of the second spectrum data S2. By making a determination according to appearance tendency of the second peak P2 of the measurement light L1 caused by the material and the first peak P1 of the measurement light L1 caused by the gas in the semiconductor process, it is possible to further enhance the accuracy for monitoring whether or not an abnormality occurs in the semiconductor process and the end point of the process.

The detection unit 4 is a CCD photodetector that includes the first horizontal shift register 43A to which the charge generated in each column of the first pixel region 41A is transferred and the second horizontal shift register 43B to which the charge generated in each column of the second pixel region 41B is transferred. With such a configuration, by using the CCD photodetector, it is possible to avoid an increase in read noise when charges generated in the pixels 42 of each column are read.

The detection unit 4 is a CCD photodetector that includes a first accumulation unit 45A that accumulates the charges generated in each column of the first pixel region 41A, a second accumulation unit 45B that accumulates the charges generated in each column of the second pixel region 41B, a first reading unit 46A that outputs the electric signal of each column according to the charges accumulated in the first accumulation unit 45A, and a second reading unit 46B that outputs the electric signal of each column according to an amount of the charges accumulated in the second accumulation unit 45B. With such a configuration, by using the CCD photodetector, it is possible to avoid an increase in read noise when charges generated in the pixels 42 of each column are read.

The detection unit 4 is a CMOS photodetector including the first reading unit 47A that outputs the electric signal according to the amount of the charges accumulated in each pixel 42 of the first pixel region 41A and the second reading unit 47B that outputs the electric signal according to the amount of the charges accumulated in each pixel 42 of the second pixel region 41B. With such a configuration, for example, power consumption can be suppressed to be lower than that of the CCD photodetector that reads the charges for each column.

The first exposure time T1 of the first pixel region 41A is controlled by the electronic shutter. With such a configuration, even in a case where the second exposure time T2 is set to be shorter and the first exposure time T1 is set to be sufficiently shorter than the second exposure time T2, the first exposure time T1 can be accurately adjusted. By setting the first exposure time T1 to be sufficiently shorter than the second exposure time T2, the dynamic range of the measurement can be further sufficiently increased.

In the semiconductor process monitoring method according to one aspect of the present disclosure, for the same reason as the semiconductor process monitoring device 1 described above, the semiconductor process can be monitored with high accuracy by measuring the intensity of the measurement light with a high dynamic range and high accuracy.

As described above, the semiconductor process monitoring method according to one aspect of the present disclosure determines whether or not an abnormality occurs in the semiconductor process based on the first spectrum data S1 obtained in the first exposure time T1 in the first pixel region 41A and determines the end point of the semiconductor process based on the second spectrum data S2 obtained in the second exposure time T2, which is longer than the first exposure time T1, in the second pixel region 41B. This semiconductor process monitoring method can measure the intensity of the spectral images P of the measurement light L1 with a high dynamic range and high accuracy, by combining the detection of the spectral image P of the measurement light L1 in the first pixel region 41A and the second pixel region 41B of which the exposure times are different from each other. Therefore, in a case where the measurement light L1 caused by the gas with relatively high intensity and the measurement light L1 caused by the material with relatively low intensity are mixed in the semiconductor process, it is possible to highly accurately monitor whether or not an abnormality occurs in the semiconductor process and the end point of the process.

Although the embodiment of the present disclosure has been described above, the present disclosure is not necessarily limited to the embodiment described above, and can be variously modified without departing from the gist of the present disclosure.

The generation unit 5 does not need to combine the data in the long wavelength region Δλ1 of the first spectrum data S1 and the data in the short wavelength region Δλ2 of the second spectrum data S2 and the generation unit 5 does not need to generate the spectrum data S of the measurement light L1. The generation unit 5 may omit step S25 in FIG. 11. In that case, the determination unit 6 may determine whether or not an abnormality occurs in the semiconductor process, based on the first spectrum data S1. Furthermore, the determination unit 6 may determine the end point of the semiconductor process, based on the second spectrum data S2. Since the generation unit 5 does not generate the spectrum data S of the measurement light L1, a calculation load of the generation unit 5 can be reduced.

The gist of the present disclosure is as described in the following [1] to [18].
[1] A semiconductor process monitoring device including: a spectroscopic unit configured to spectrally disperse measurement light from a chamber; a detection unit configured to detect a spectral image of the measurement light spectrally dispersed by the spectroscopic unit; and a determination unit configured to determine a progress status of a semiconductor process in the chamber, based on data obtained from a detection result of the spectral image of the measurement light, in which the spectroscopic unit wavelength-resolves the measurement light in a first direction and forms a spectral image for each wavelength in a second direction intersecting with the first direction, the detection unit includes a first pixel region and a second pixel region divided along the second direction, and the determination unit determines whether or not an abnormality occurs in the semiconductor process based on first spectrum data obtained in a first exposure time in the first pixel region and determines an end point of the semiconductor process based on second spectrum data obtained in a second exposure time, which is longer than the first exposure time, in the second pixel region.
[2] The semiconductor process monitoring device according to [1], in which in the first pixel region, the first exposure time is set to be shorter than a first frame time in the first pixel region, and in the second pixel region, the second exposure time is set to be the same as a second frame time in the second pixel region.
[3] The semiconductor process monitoring device according to [1] or [2], in which in the first pixel region, the first exposure time is set so that the measurement light is not saturated at least in a long wavelength region of the measurement light, and in the second pixel region, the second exposure time is set so that the measurement light is not saturated at least in a short wavelength region of the measurement light.
[4] The semiconductor process monitoring device according to [1] or [2], further including a generation unit configured to combine data in a long wavelength region of the first spectrum data and data in a short wavelength region of the second spectrum data and output the data to the determination unit.
[5] The semiconductor process monitoring device according to any one of [1] to [4], in which the determination unit determines whether or not an abnormality occurs in the semiconductor process, based on whether or not a first peak appears in a predetermined wavelength in the long wavelength region of the first spectrum data and determines the end point of the semiconductor process, in a case where a second peak appears in a predetermined wavelength in the short wavelength region of the second spectrum data.
[6] The semiconductor process monitoring device according to any one of [1] to [5], in which the detection unit is a CCD photodetector that includes a first horizontal shift register to which a charge generated in each column of the first pixel region is transferred and a second horizontal shift register to which a charge generated in each column of the second pixel region is transferred.
[7] The semiconductor process monitoring device according to any one of [1] to [5], in which the detection unit is a CCD photodetector that includes a first accumulation unit in which the charges generated in each column of the first pixel region are accumulated, a second accumulation unit in which the charges generated in each column of the second pixel region are accumulated, a first reading unit configured to output an electrical signal of each column according to an amount of the charges accumulated in the first accumulation unit, and a second reading unit configured to output an electrical signal of each column according to an amount of the charges accumulated in the second accumulation unit.
[8] The semiconductor process monitoring device according to any one of [1] to [5], in which the detection unit is a CMOS photodetector that includes a first reading unit configured to output an electric signal according to an amount of charges accumulated in each pixel of the first pixel region and a second reading unit configured to output an electric signal according to an amount of charges accumulated in each pixel of the second pixel region.
[9] The semiconductor process monitoring device according to any one of [1] to [8], in which the first exposure time of the first pixel region is controlled by an electronic shutter.
[10] A semiconductor process monitoring method including: a spectroscopic step of spectrally dispersing measurement light from a chamber; a detection step of detecting a spectral image of the measurement light spectrally dispersed by the spectroscopic step; and a determination step of determining a progress status of a semiconductor process in the chamber, based on data obtained from a detection result of the spectral image of the measurement light, in which in the spectroscopic step, the measurement light is wavelength-resolved in a first direction, and a spectral image is formed for each wavelength in a second direction intersecting with the first direction, in the detection step, a photodetector including a first pixel region and a second pixel region divided along the second direction detects the spectral image, and in the determination step, it is determined whether or not an abnormality occurs in the semiconductor process based on first spectrum data obtained in a first exposure time in the first pixel region, and an end point of the semiconductor process is determined based on second spectrum data obtained in a second exposure time, which is longer than the first exposure time, in the second pixel region.
[11] The semiconductor process monitoring method according to [10], in which in the detection step, in the first pixel region, the first exposure time is set to be shorter than a first frame time in the first pixel region, and in the second pixel region, the second exposure time is set to be the same as a second frame time in the second pixel region.
[12] The semiconductor process monitoring method according to [10] or [11], in which in the detection step, in the first pixel region, the first exposure time is set so that the measurement light is not saturated at least in a long wavelength region of the measurement light, and in the second pixel region, the second exposure time is set so that the measurement light is not saturated at least in a short wavelength region of the measurement light.
[13] The semiconductor process monitoring method according to [10] or [11], further including: a generation step of combining data in a long wavelength region of the first spectrum data and data in a short wavelength region of the second spectrum data and outputting the data to the determination unit.
[14] The semiconductor process monitoring method according to any one of [10] to [13], in which in the determination step, it is determined whether or not an abnormality occurs in the semiconductor process, based on whether or not a first peak appears in a predetermined wavelength in the long wavelength region of the first spectrum data, and the end point of the semiconductor process is determined, in a case where a second peak appears in a predetermined wavelength in the short wavelength region of the second spectrum data.
[15] The semiconductor process monitoring method according to any one of [10] to [14], in which in the detection step, a CCD photodetector is used that includes a first horizontal shift register to which a charge generated in each column of the first pixel region is transferred and a second horizontal shift register to which a charge generated in each column of the second pixel region is transferred.
[16] The semiconductor process monitoring method according to any one of [10] to [15], in which in the detection step, a CCD photodetector is used that includes a first accumulation unit in which the charges generated in each column of the first pixel region are accumulated, a second accumulation unit in which the charges generated in each column of the second pixel region are accumulated, a first reading unit configured to output an electrical signal of each column according to an amount of the charges accumulated in the first accumulation unit, and a second reading unit configured to output an electrical signal of each column according to an amount of the charges accumulated in the second accumulation unit.
[17] The semiconductor process monitoring method according to any one of [10] to [15], in which in the detection unit step, a CMOS photodetector is used that includes a first reading unit configured to output an electric signal according to an amount of charges accumulated in each pixel of the first pixel region and a second reading unit configured to output an electric signal according to an amount of charges accumulated in each pixel of the second pixel region.
[18] The semiconductor process monitoring method according to any one of [10] to [17], in which in the detection step, the first exposure time of the first pixel region is controlled by an electronic shutter.

### Reference Signs List

1 semiconductor process monitoring device
3 spectroscopic unit
4, 4A, 4B, 4C detection unit
5 generation unit
6 determination unit
41A first pixel region
41B second pixel region
42 pixel
43A first horizontal shift register
43B second horizontal shift register
45A first accumulation unit
45B second accumulation unit
46A, 47A first reading unit
46B, 47B second reading unit
81 chamber
L1 measurement light
P1 first peak
P2 second peak
S spectrum data
S1 first spectrum data
S2 second spectrum data
S11 spectroscopic step
S12 detection step
S14 determination step
T1 first exposure time
T2 second exposure time
Δλ1 long wavelength region
Δλ2 short wavelength region

## Claims

1. A semiconductor process monitoring device comprising:
a spectroscopic unit configured to spectrally disperse measurement light from a chamber;
a detection unit configured to detect a spectral image of the measurement light spectrally dispersed by the spectroscopic unit; and
a determination unit configured to determine a progress status of a semiconductor process in the chamber, based on data obtained from a detection result of the spectral image of the measurement light,
wherein
the spectroscopic unit wavelength-resolves the measurement light in a first direction and forms a spectral image for each wavelength in a second direction intersecting with the first direction,
the detection unit includes a first pixel region and a second pixel region divided along the second direction, and
the determination unit determines whether or not an abnormality occurs in the semiconductor process based on first spectrum data obtained in a first exposure time in the first pixel region and determines an end point of the semiconductor process based on second spectrum data obtained in a second exposure time, which is longer than the first exposure time, in the second pixel region.

2. The semiconductor process monitoring device according to claim 1, wherein
in the first pixel region, the first exposure time is set to be shorter than a first frame time in the first pixel region, and
in the second pixel region, the second exposure time is set to be the same as a second frame time in the second pixel region.

3. The semiconductor process monitoring device according to claim 1, wherein
in the first pixel region, the first exposure time is set so that the measurement light is not saturated at least in a long wavelength region of the measurement light, and
in the second pixel region, the second exposure time is set so that the measurement light is not saturated at least in a short wavelength region of the measurement light.

4. The semiconductor process monitoring device according to any one of claims 1 to 3, further comprising a generation unit configured to combine data in a long wavelength region of the first spectrum data and data in a short wavelength region of the second spectrum data and output the data to the determination unit.

5. The semiconductor process monitoring device according to any one of claims 1 to 3, wherein the determination unit determines whether or not an abnormality occurs in the semiconductor process, based on whether or not a first peak appears in a predetermined wavelength in the long wavelength region of the first spectrum data and determines an end point of the semiconductor process, in a case where a second peak appears in a predetermined wavelength in the short wavelength region of the second spectrum data.

6. The semiconductor process monitoring device according to any one of claims 1 to 3, wherein
the detection unit is a CCD photodetector including
a first horizontal shift register to which a charge generated in each column of the first pixel region is transferred and
a second horizontal shift register to which a charge generated in each column of the second pixel region is transferred.

7. The semiconductor process monitoring device according to any one of claims 1 to 3, wherein
the detection unit is a CCD photodetector including
a first accumulation unit in which the charges generated in each column of the first pixel region are accumulated,
a second accumulation unit in which the charges generated in each column of the second pixel region are accumulated,
a first reading unit configured to output an electrical signal of each column according to an amount of the charges accumulated in the first accumulation unit, and
a second reading unit configured to output an electrical signal of each column according to an amount of the charges accumulated in the second accumulation unit.

8. The semiconductor process monitoring device according to any one of claims 1 to 3, wherein
the detection unit is a CMOS photodetector including
a first reading unit configured to output an electric signal according to an amount of charges accumulated in each pixel of the first pixel region and
a second reading unit configured to output an electric signal according to an amount of charges accumulated in each pixel of the second pixel region.

9. The semiconductor process monitoring device according to any one of claims 1 to 3, wherein the first exposure time of the first pixel region is controlled by an electronic shutter.

10. A semiconductor process monitoring method comprising:
spectrally dispersing measurement light from a chamber;
detecting a spectral image of the measurement light spectrally dispersed by the spectrally dispersing measurement light; and
determining a progress status of a semiconductor process in the chamber, based on data obtained from a detection result of the spectral image of the measurement light,
wherein
in the spectrally dispersing measurement light, the measurement light is wavelength-resolved in a first direction, and a spectral image is formed for each wavelength in a second direction intersecting with the first direction,
in the detecting a spectral image of the measurement light, a photodetector including a first pixel region and a second pixel region divided along the second direction detects the spectral image, and
in the determining a progress status of a semiconductor process in the chamber, it is determined whether or not an abnormality occurs in the semiconductor process based on first spectrum data obtained in a first exposure time in the first pixel region, and an end point of the semiconductor process is determined based on second spectrum data obtained in a second exposure time, which is longer than the first exposure time, in the second pixel region.
